(19)

Europäisches
Patentamt
European
Patent Office
Office européen
des brevets

(11) **EP 2 624 316 A1**

(12) **EUROPEAN PATENT APPLICATION**
published in accordance with Art. 153(4) EPC

(43) Date of publication:
**07.08.2013 Bulletin 2013/32**

(21) Application number: **10857907.9**

(22) Date of filing: **30.09.2010**

(51) Int Cl.:
*H01L 31/115* (2006.01)     *G01T 1/24* (2006.01)

(86) International application number:
**PCT/KR2010/006689**

(87) International publication number:
**WO 2012/043906 (05.04.2012 Gazette 2012/14)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(71) Applicant: DRTech Corporation
**Seongnam-si, Gyeonggi-do 463-954 (KR)**

(72) Inventors:
• **KIM, Jung-Seok**
**Chungcheongbuk-do 360-070 (KR)**
• **KO, Byung-Hun**
**Seongnam-si**
**Gyeonggi-do 463-030 (KR)**

• **MOON, Beom-Jin**
**Suwon-si**
**Gyeonggi-do 443-737 (KR)**
• **YOON, Jung-Kee**
**Anyang-si**
**Gyeonggi-do 431-070 (KR)**

(74) Representative: **Walaski, Jan Filip et al**
**Venner Shipley LLP**
**200 Aldersgate**
**London**
**EC1A 4HD (GB)**

(54)     **RADIATION DETECTOR AND METHOD FOR DETECTING RADIATION**

(57)     Disclosed are a radiation detector and a method for detecting radiation, which can increase image resolution and improve a complicated manufacturing process. The radiation detector comprises: an upper electrode layer which transmits radiation; a first photoconductive layer which represents photoconductivity by the radiation; an electric charge-collecting layer which collects electric charges by the photoconductivity at the first photoconductive layer, and operates as a floating electrode; a second photoconductive layer which represents photoconductivity by a reading backlight; a lower transparent electrode layer which is electrified by the electric charges that are collected by the electric charge-collecting layer; and a backlight irradiation unit which applies the backlight to the second photoconductive layer in a pixel unit through the lower transparent electrode layer, wherein the invention comprises a data processing unit, which reads signals corresponding to the electric charges that are collected in the electric charge-collecting layer from the lower transparent electrode layer according to the irradiation of the backlight, and which generates radiation images by using the read signals.

FIG. 1

EP 2 624 316 A1

**Description**

Technical Field

The present invention relates to an apparatus and method for detecting radiation, which can detect radiation such as X-rays and can thus generate image data.

Background Art

Digital radiation detection apparatuses are devices that obtain information on the inside of the human body through X-ray irradiation without a requirement of films, detect electric image signals from the obtained information with the use of image detection sensors and generate a digital image based on the electrical image signals. Digital radiation detection apparatuses are largely classified into direct-type and indirect-type digital radiation detection apparatuses. Direct-type digital radiation detection apparatuses directly detect electric signals generated by irradiating the human body using amorphous selenium (a-Se) and thin film transistors (TFTs). Indirect-type digital radiation detection apparatuses use light receptors such as charge-coupled deices (CCDs) or photodiodes and thus obtain radiation images from light emitted by phosphors (such as CsI) that convert radiation into visible light. Indirect-type digital radiation detection apparatuses have a relatively low resolution, compared to direct-type digital radiation detection apparatuses.

Conventional radiation detection apparatuses using TFTs are likely to result in a considerable amount of noise. The greater the size of radiation detection apparatuses, the greater the amount of noise generated, and the lower the detective quantum efficiency. In addition, since a TFT is required for each pixel in a panel, radiation detection apparatuses are generally difficult and costly to manufacture on a large scale.

Technical Problem

An apparatus and method for detecting radiation, which can improve the resolution of radiation images and can contribute to the simplification of the manufacture of the apparatus, are required.

Technical Solution

The present invention provides an apparatus and method for detecting radiation, which can improve the resolution of radiation images and can contribute to the simplification of the manufacture of the apparatus.

Additional features of the invention will be set forth in the description which follows, and in part will be apparent from the description, or may be learned by practice of the invention.

Advantageous Effects

According to an exemplary embodiment, the present invention may provide an apparatus and method for detecting radiation, which can improve the resolution of radiation images and can contribute to the simplification of the manufacture of the apparatus.

Description of Drawings

The accompanying drawings, which are included to provide a further understanding of the invention and are incorporated in and constitute a part of this specification, illustrate embodiments of the invention, and together with the description serve to explain the principles of the invention.

FIG. 1 is a cross-sectional view of an exemplary apparatus for detecting radiation;
FIG. 2 is a circuit diagram for explaining the operation of first and second photoconductive layers shown in FIG. 1;
FIG. 3 is a cross-sectional view of another exemplary apparatus for detecting radiation, which uses a plasma display panel (PDP);
FIGS. 4A through 4E are cross-sectional views for explaining the operation of another exemplary apparatus for detecting radiation, which includes a metal layer as a charge trapping layer;
FIGS. 5A through 5D are cross-sectional views for explaining the operation of another exemplary apparatus for detecting radiation, which includes a dielectric layer as a charge trapping layer;
FIGS. 6A through 6D are cross-sectional views for explaining the operation of another exemplary apparatus for detecting radiation, which includes the combination of a metal layer and a dielectric layer as a charge trapping layer; and
FIG. 7 is a flowchart of an exemplary method of detecting radiation.

Best Mode

In one general aspect, the present invention discloses an apparatus for detecting radiation, the apparatus including an upper electrode layer transmitting radiation; a first photoconductive layer becoming photoconductive upon exposure to the radiation and thus generating charges therein; a charge trapping layer trapping therein the charges generated in the first photoconductive layer and serving as a floating electrode; a second photoconductive layer becoming photoconductive upon exposure to rear light for reading out a radiation image; a lower transparent electrode layer charged with the charges trapped in the charge trapping layer; a rear light emission unit applying the rear light to the second photoconductive layer via the lower transparent electrode layer in units of pixels; and a data processing unit reading out a signal corresponding to the charges trapped in the charge trapping layer from the lower transparent electrode layer and generating a radiation image based on the read-out signal

In another general aspect, the present invention also discloses a method for detecting radiation, which is performed by an apparatus for detecting radiation, including an upper electrode layer transmitting radiation, a first photoconductive layer becoming photoconductive upon exposure to the radiation and thus generating charges therein, a charge trapping layer trapping therein the charges generated in the first photoconductive layer and serving as a floating electrode, a second photoconductive layer becoming photoconductive upon exposure to rear light for reading out a radiation image, a lower transparent electrode layer charged with the charges trapped in the charge trapping layer, and a rear light emission unit applying the rear light to the second photoconductive layer via the lower transparent electrode layer in units of pixels, the method including generating pairs of positive and negative charges in the first photoconductive layer upon exposure to radiation when applying a high voltage to the upper electrode layer; separating the positive and negative charges from each other and moving the positive and negative charges toward the upper electrode layer and the charge trapping layer, respectively; trapping the positive or negative charges in the charge trapping layer; connecting the upper electrode layer to a ground source and generating pairs of positive and negative charges in the second photoconductive layer upon exposure to the rear light; and reading out a signal corresponding to the charges trapped in the charge trapping layer from the lower transparent electrode layer, the charges trapped in the charge trapping layer originating from the second photoconductive layer.

It is to be understood that both the foregoing general description and the following detailed description are exemplary and explanatory and are intended to provide further explanation of the invention as claimed.

Mode for Invention

The invention is described more fully hereinafter with reference to the accompanying drawings, in which exemplary embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers and regions may be exaggerated for clarity. Like reference numerals in the drawings denote like elements.

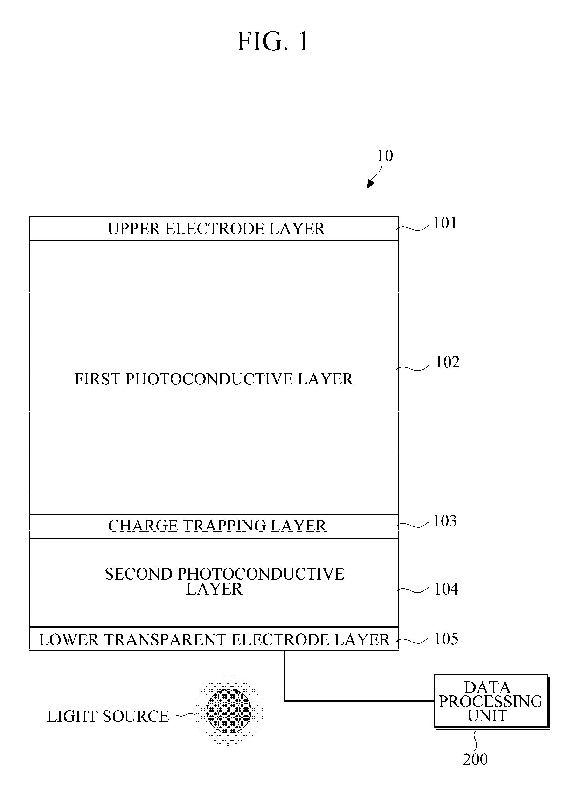

FIG. 1 is a cross-sectional view of an exemplary apparatus 10 for detecting radiation. Referring to FIG. 1, the apparatus 10 may include an upper electrode layer 101, a first photoconductive layer 102, a charge trapping layer 103, a second photoconductive layer 104, a lower transparent electrode layer 105 and a data processing unit 200. The upper electrode layer 101 may transmit radiation incident thereupon from an external source to the first photoconductive layer 102. Examples of the radiation include, but are not limited to X-rays, alpha rays and gamma rays.

The first photoconductive layer 102 may become photoconductive upon exposure to the radiation transmitted thereto by the upper electrode layer 101. That is, the first photoconductive layer 102 may generate pairs of positive and negative charges (i.e., holes and electrons) upon exposure to radiation. The amount of charges generated by the first photoconductive layer 102 may be proportional to the intensity of radiation transmitted to the first photoconductive layer 102. The amount of radiation that reaches the first photoconductive layer 102 may vary according to the composition of an object (such as the human body), if any, placed on the upper electrode layer 101. The first photoconductive layer 102 may be formed of amorphous selenium (a-Se), $As_2Se_3$ or an asbestos (As)-contained a-Se compound.

The charge trapping layer 103 may trap therein the positive and negative charges generated in the first photoconductive layer 102, and may thus serve as a floating electrode. More specifically, the charge trapping layer 103 may block the charges collected from the first photoconductive layer 102 and accumulated between the first photoconductive layer 102 and the charge trapping layer 103. The charge trapping layer 103 may include a metal layer, a dielectric layer or the combination thereof.

The second photoconductive layer 104 may become photoconductive upon exposure to rear light for reading out a radiation image. The second photoconductive layer 104 may generate pairs of positive and negative charges upon exposure to rear light. The amount of positive and negative charges generated in the second photoconductive layer 104 may be proportional to the intensity of rear light transmitted to the second photoconductive layer 104. The second photoconductive layer 124 may be formed of a-Se, $As_2Se_3$ or an As-contained a-Se compound.

The term 'rear light,' as used herein, indicates light irradiated from an opposite side of the apparatus 10 with respect to the direction of radiation. Examples of a rear light source include, but are not limited to, various light source systems capable of applying light in units of pixels, such as a liquid crystal display (LCD), a plasma display panel (PDP), a light-emitting diode (LED), a field emission display (FED), and a laser light source.

The lower transparent electrode layer 105 may be charged with the charges trapped in the charge trapping layer 103. The lower transparent electrode layer 105 may be formed of a transparent material and may thus be able to transmit rear light therethrough to the second photoconductive layer 104. More specifically, the lower transparent electrode layer 105 may be formed of a transparent material such as indium tin oxide (ITO) or indium zinc oxide (IZO). Once pairs of positive and negative charges are generated in the second photoconductive layer 104, the lower transparent electrode layer 105 may be charged with the opposite polarity to that of the charges trapped in the charge trapping layer 103.

The data processing unit 200 may read out a signal corresponding to the charges in the lower transparent electrode layer 105 and may thus generate a radiation image. FIG. 1 illustrates the structure of a portion of the apparatus 10 corresponding to a pixel. Thus, the data processing unit 200 may perform the reading out of the signal in units of pixels or rows or columns of pixels in a pixel array in the apparatus 10 and may thus obtain a whole radiation image.

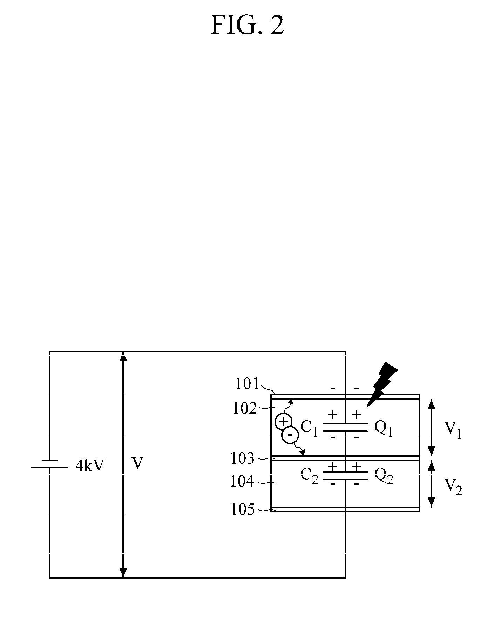

FIG. 2 is a circuit diagram for explaining the operation of the first and second photoconductive layers 102 and 104, which are stacked with the charge trapping layer 103 interposed therebetween. Referring to FIG. 2, when radiation is transmitted to the first photoconductive layer 102 by the upper electrode layer 101, pairs of positive and negative charges may be generated in the first photoconductive layer 102. An electric field may be generated in the upper electrode layer 101 in response to a high voltage of, for example, 4 kV, applied to the upper electrode layer 101. Then, the positive and negative charges in the first photoconductive layer 102 may move toward opposite directions. As a result, positive or negative charges may be trapped in the charge trapping layer 103. More specifically, if a negative voltage is applied to the upper electrode layer 101, the positive charges in the first photoconductive layer 102 may move toward the upper electrode layer 101, whereas the negative charges in the photoconductive layer 102 may move toward the charge trapping layer 103.

Referring to FIG. 2, the first and second photoconductive layers 102 and 104, which are stacked with the charge trapping layer 103 interposed therebetween, may serve as capacitors connected in series. The relationship between capacitance C and energy W may be defined by the following equation: $W = \frac{1}{2}CV^2$. Since

a charge quantity $Q_1$ of the first photoconductive layer 102 is the same as a charge quantity $Q_2$ of the second photoconductive layer 104, $\frac{1}{2}C_1V_1^2 = \frac{1}{2}C_2V_2^2$ where $C_1$ and $C_2$ respectively in-

dicate the capacitances of the first and second photoconductive layers 102 and 104, and $V_1$ and $V_2$ respectively indicate the voltages of the first and second photoconductive layers 102 and 104. In addition, since

$C = \varepsilon_o \frac{A}{d}$ and $V = Ed$ , $\frac{1}{2}\varepsilon_o A E_1^2 d_1 = \frac{1}{2}\varepsilon_o A E_2^2 d_2$ where $d_1$

and $d_2$ respectively indicate the thicknesses of the first and second photoconductive layers 102 and 104 and $E_1$ and $E_2$ respectively indicate the electric fields applied to the first and second photoconductive layers 102 and 104. The thickness $d_1$ of the first photoconductive layer 102 may be much greater than the thickness $d_2$ of the second photoconductive layer 104. For example, the thickness $d_1$ of the first photoconductive layer 102 may be about 500 $\mu$m, and the thickness $d_2$ of the second photoconductive layer 104 may be about 7-12 $\mu$m. Thus, the magnitude of the electric field $E_2$ applied to the second photoconductive layer 104 may be greater than the magnitude of the electric field $E_1$ applied to the first photoconductive layer 102. During an image recording operation, a high voltage may be applied to the upper electrode layer 101, whereas, during a radiation image read-out operation, a ground voltage may be applied to the upper electrode layer 101. Therefore, most of the electric field generated in the apparatus 10 may be applied to the second photoconductive layer 104.

Referring to FIG. 2, the charges (regardless of whether positive or negative) generated in the first photoconductive layer 102 may be blocked by an energy barrier between the charge trapping layer 103 and the first photoconductive layer 102. Even when blocked by the charge trapping layer 103, electrons can jump over the energy barrier if the energy barrier becomes low due to, for example, a variation in the electric field or temperature outside the charge trapping layer 103. However, since the electric field applied to the first photoconductive layer 102 is much weaker than the electric field applied to the second photoconductive layer 104, there is no sufficient external energy for the charges generated in the first photoconductive layer 102 to jump over the energy barrier. Thus, the charges generated in the first photoconductive layer 102 can be effectively blocked by the charge trapping layer 103.

If rear light is applied to the second photoconductive layer 104 when the negative charges are blocked by the charge trapping layer 103, pairs of positive and negative charges may be generated in the second photoconductive layer 104. In this case, the positive charges in the second photoconductive layer 104 may move toward the charge trapping layer 103, and thus, the surface of the charge trapping layer 103 may be electrically neutralized. The negative charges in the second photoconductive layer 104 may move toward the lower transparent electrode layer 105 and may thus be subjected to a radiation image read-out operation. In short, the negative charges trapped in the charge trapping layer 103 may be read out, and image processing may be performed on the read-out negative charges, thereby obtaining a radiation image.

The energy band at the interface between the charge trapping layer 103 and the first photoconductive layer 102 may depend on the difference between the work function of a conductive material of the charge trapping layer 103 and the work function of the first photoconductive layer 102, and may be adjusted according to the physical properties of the charge trapping layer 103 and the first photoconductive layer 102 such as thickness and specific resistance.

In order to properly trap charges in the charge trapping layer upon exposure to radiation, the charge trapping layer 103 may be formed as a metal layer, a dielectric layer or the combination thereof. More specifically, the charge trapping layer 103 may be formed as a metal layer by using silver (Ag), copper (Cu), gold (Au), aluminum (Al), calcium (Ca), tungsten (W), zinc (Zn), nickel (Ni), iron (Fe), platinum (Pt), tin (Sn), lead (Pb), manganese (Mn), constantan, mercury (Hg), nichrome, carbon (C), germanium (Ge), silicon (Si), glass, quartz, polyethylene terephtalate (PET), or Teflon. Alternatively, the charge trapping layer 123 may be formed as a dielectric layer by using an organic dielectric material such as benzocyclobutene (BCB), parylene, a-C:H(F), polyimide (PI), polyarylene ether, or fluorinated amorphous carbon, an inorganic dielectric material such as $SiO_2$, $Si_3N_4$, polysilsequioxane, or methyl silane, or a porous dielectric material such as xetogel/aerogel or polycaprolactone (PCL). By forming the charge trapping layer 103 as a metal layer, a dielectric layer or the combination thereof, it is possible to simplify the fabrication of the charge trapping layer 103, effectively trap the charges generated in the first photoconductive layer 102 in the charge trapping layer 103 and reduce the time and cost required to manufacture the apparatus 10, compared to the case when the charge trapping layer 103 is formed of doped semiconductor. Thus, it is possible to improve the resolution of a radiation image and simplify the manufacture of the apparatus 10.

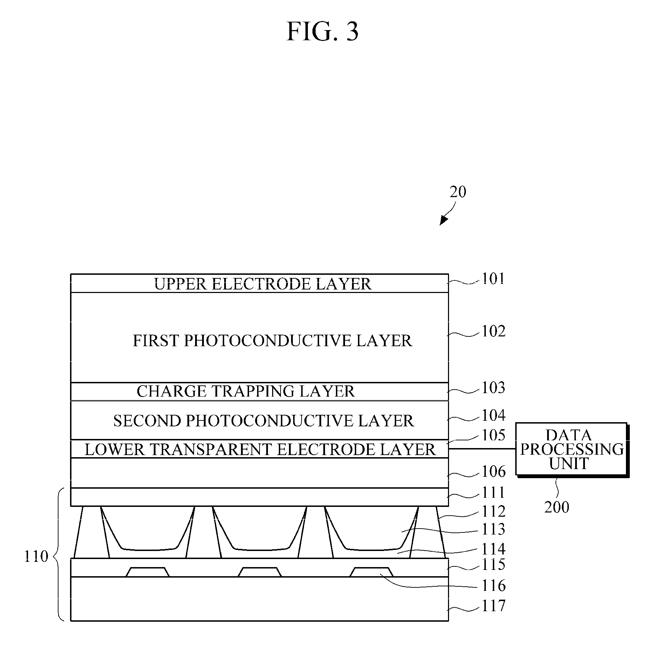

FIG. 3 is a cross-sectional view of another exemplary apparatus 20 for detecting radiation, which uses a plasma display panel (PDP). Referring to FIG. 3, the apparatus 20 may include an upper electrode layer 101, a first photoconductive layer 102, a charge trapping layer 103, a second photoconductive layer 104, a lower transparent electrode layer 105, an intermediate substrate 106 and a PDP 110. The PDP 110, the lower transparent electrode layer 105, the second photoconductive layer 104, the charge trapping layer 103, the first photoconductive layer 102, and the upper electrode layer 101 may be sequentially stacked. The intermediate substrate 106 may support the upper electrode layer 101, the first photoconductive layer 102, the charge trapping layer 103, the second photoconductive layer 104 and the lower transparent electrode layer 105, and may be formed of, for example, glass.

The upper electrode layer 101, the first photoconductive layer 102, the charge trapping layer 103, the second photoconductive layer 104, and the lower transparent electrode layer 105 are the same as their respective counterparts shown in FIG. 1, and thus, detailed descriptions thereof will be omitted.

The PDP 110 may provide plasma light as rear light. The PDP 110 may include a first substrate 111, a plurality of barrier ribs 112, a gas layer 113, a plurality of phosphor layers 114, an insulating layer 115, a plurality of electrodes 116 and a second substrate 117.

The first and second substrates 111 and 112 may face each other.

The barrier ribs 112 may define a cell structure between the first and second substrates 111 and 112. More specifically, the barrier ribs 112 may be formed between the first substrate 111 and the insulating layer 115 and may thus form a sealed cell structure. The barrier ribs 112 may define a plurality of pixels of the PDP 110. The barrier ribs 112 may prevent crosstalk between the pixels. The barrier ribs 112 may be formed in various shapes such as 2-, 6-, and 8-directional shapes according to the shape of pixels. The barrier ribs 112 may determine the resolution of the PDP 110. The barrier ribs 112 may be formed using the same method used to manufacture a typical PDP. The area and height of the barrier ribs 112 can be appropriately adjusted in order to increase the reaction area of each pixel for radiation.

The gas layer 113 may be disposed in an inner chamber within the cell structure formed by each of the barrier ribs 112, and may generate a plasma discharge. Plasma light generated by the gas layer 113 may be provided to the lower transparent electrode layer 105.

The phosphor layers 114 may reflect plasma light generated by the gas layer 113 and may thus enable high-intensity plasma light to be provided to the lower transparent electrode layer 105. The phosphor layers 114 may be formed between the insulating layer 115 and the barrier ribs 112. The phosphor layers 114 may be optional.

The insulating layer 115 may be formed on the second substrate 117 as a dielectric layer. The insulating layer 115 may prevent the electrodes 116, which are arranged in units of pixels, from being short-circuited and may also prevent a leakage current. The electrodes 116 may transmit power for generating plasma to the gas layer 113.

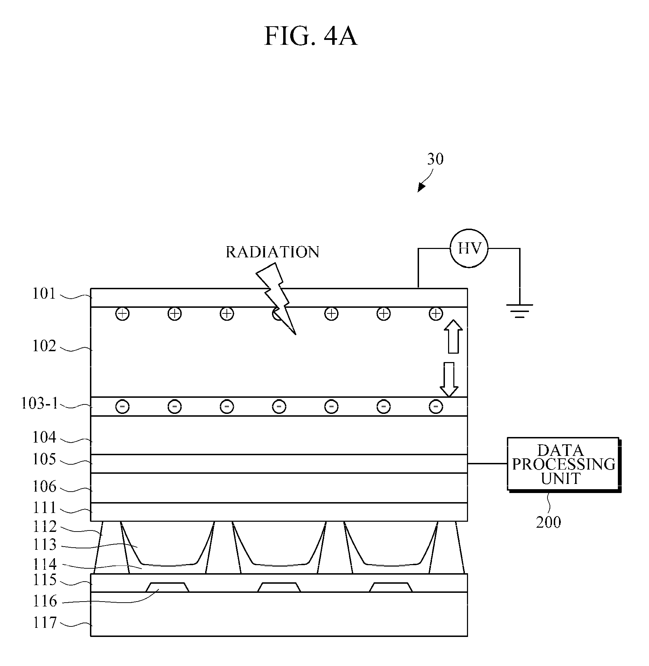

FIGS. 4A through 4E are cross-sectional views for explaining the operation of another exemplary apparatus 20 for detecting radiation, which includes a metal layer 103-1 as a charge trapping layer. The apparatus 30 may be the same as the apparatus 20 shown in FIG. 3 except that it includes the metal layer 103-1 formed of a metal. In FIGS. 4A through 4E, the plus sign '+' indicates a positive charge, and the negative sign '-' indicates a negative charge.

Referring to FIG. 4A, when radiation such as X-rays is applied to the apparatus 30, the radiation may be transmitted to a first photoconductive layer 102 through an upper electrode layer 101, and pairs of positive and negative charges may be generated in the first photoconductive layer 102. When a high voltage HV is applied to the upper electrode layer 101, the positive and negative charges may be separated from each other and may move toward opposite directions. More specifically, if a negative voltage is applied to the first photoconductive layer 102, the positive charges in the first photoconductive layer 102 may move toward the upper electrode layer 101, and the negative charges in the first photoconductive layer 102 may move toward the metal layer 103-1.

The negative charges moving toward the metal layer 103-1 may be trapped in the metal layer 103-1. That is, the negative charges generated in the first photoconductive layer 102 may move toward the metal layer 103-1 and may thus accumulate at the interface between the first photoconductive layer 102 and the metal layer 103-1. The negative charges accumulated between the first photoconductive layer 102 and the metal layer 103-1 can be blocked by a weak electric field applied to the first photoconductive layer 102, as described above with reference to FIG. 2. Since the amount of radiation transmitted through an object (such as the human body), if any, placed on the apparatus 30 varies according to the composition and shape of the object, the amount of positive and negative charges generated in the first photoconductive layer 102 and the amount of negative charges trapped in the metal layer 103-1 may also vary according to the composition and shape of the object. Therefore, the amount of negative charges trapped in the metal layer 103-1 may correspond to a radiation image recorded by the apparatus 30.

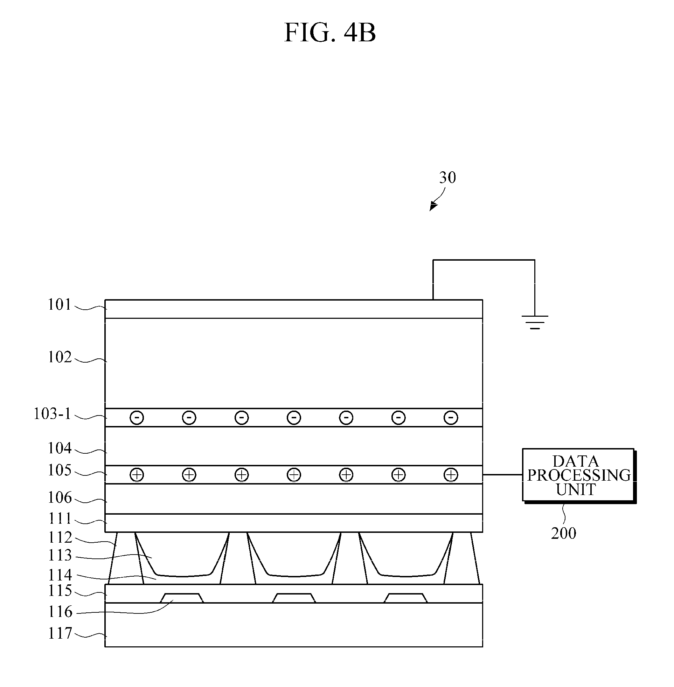

Once negative charges are trapped in the metal layer 103-1, a second photoconductive layer 104 can serve as a capacitor. As a result, referring to FIG. 4B, a lower transparent electrode layer 105 may be charged with positive charges. More specifically, the lower transparent electrode layer 105 may be charged with a number of positive charges corresponding to the number of negative charges trapped in the metal layer 103-1.

A radiation image read-out operation will hereinafter be described in detail. If a first row of pixels in the pixel array of a PDP 110 is turned on, plasma light may be emitted from the first row of pixels. The plasma light may transmit through the lower transparent electrode layer 105, and may thus reach the second photoconductive layer 104.

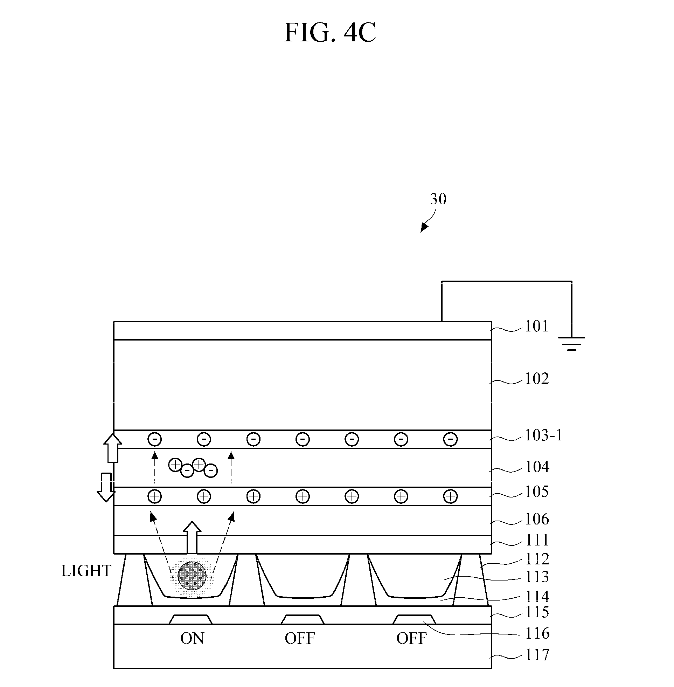

Due to the plasma light, pairs of positive and negative charges may be generated in the second photoconductive layer 104, and particularly, in a portion of the second photoconductive layer 104 corresponding to the first row of pixels. Referring to FIG. 4C, the positive charges in the second photoconductive layer 104 may be electrically attracted to the negative charges trapped in the metal layer 103-1, and the negative charges in the second photoconductive layer 104 may be electrically attracted to the positive charges in the lower transparent electrode layer 105. As a result, the positive and negative charges in the second photoconductive layer 104 may be separated from each other.

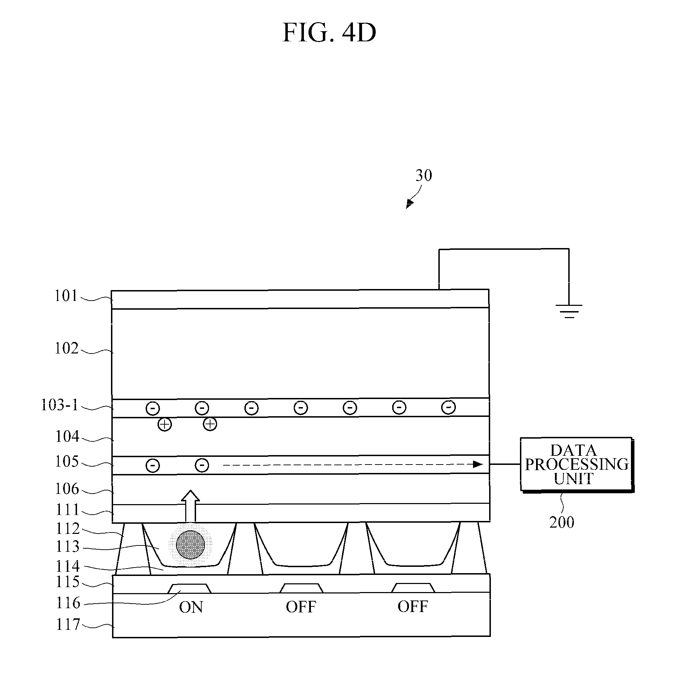

Thereafter, referring to FIG. 4D, due to the positive charges in the lower transparent electrode layer 105, the negative charges generated by the second photoconductive layer 104 may be read out from the first row of pixels by a data processing unit 200. Then, the read-out negative charges may be subjected to image processing performed by the data processing unit 200.

The positive charges generated in the second photoconductive layer 104 may move toward the metal layer 103-1 due to the negative charges trapped in the metal layer 103-1, and thus, the metal layer 103-1 may be electrically neutralized.

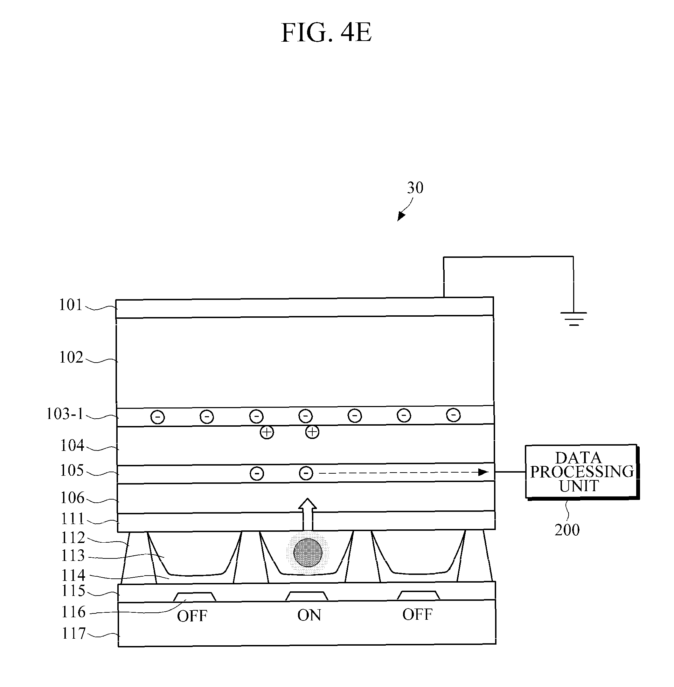

Thereafter, referring to FIG. 4E, the first row of pixels may be turned off, and a second row of pixels may be turned on. Then, the second row of pixels may emit plasma light. Due to the plasma light, pairs of positive and negative charges may be generated in a portion of the second photoconductive layer 104 corresponding to the second row of pixels. The positive and negative charges generated in the second photoconductive layer 104 may be electrically attracted to the metal layer 103-1 and the lower transparent electrode layer 105, respectively, and may thus be separated from each other. Due to the positive charges in the lower transparent electrode layer 105, negative charges may be read out from the portion of the second photoconductive layer 104 corresponding to the second row of pixels by the data processing unit 200. Then, the read-out negative charges may be subjected to image processing performed by the data processing unit 200.

Thereafter, the same operation as that performed on the first and second rows of pixels may also be performed on a third row of pixels. As a result, negative charges may be read out from a portion of the second photoconductive layer 104 corresponding to the third row of pixels by the data processing unit 200. Then, the read-out negative charges may be subjected to image processing performed by the data processing unit 200.

By performing the above-mentioned operation on all rows of pixels in the PDP 110, it is possible to obtain a radiation image of an object, if any, placed on the apparatus 30.

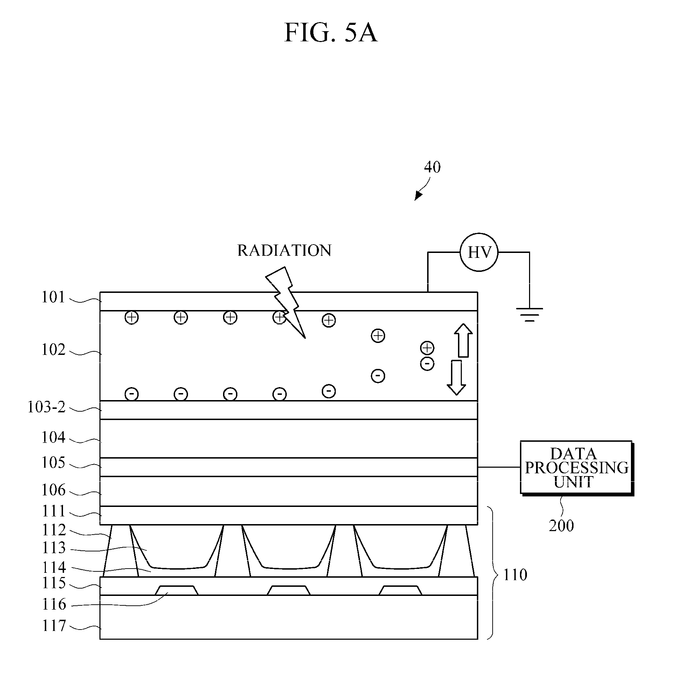

FIGS. 5A through 5D are cross-sectional views for explaining the operation of another exemplary apparatus 40 for detecting radiation, which includes a dielectric layer 103-2 as a charge trapping layer. The apparatus 40 is the same as the apparatus 20 shown in FIG. 3 except that it includes the dielectric material 103-2 as a charge trapping layer.

Referring to FIG. 5A, when radiation such as X-rays is applied to the apparatus 40, the radiation may be transmitted to a first photoconductive layer 102 through an upper electrode layer 101, and pairs of positive and negative charges may be generated in the first photoconductive layer 102. When a high voltage HV is applied to the upper electrode layer 101, the positive and negative charges may be separated from each other and may move toward opposite directions. More specifically, if a negative voltage is applied to the first photoconductive layer 102, the positive charges in the first photoconductive layer 102 may move toward the upper electrode layer 101, and the negative charges in the first photoconductive layer 102 may move toward the dielectric layer 103-2.

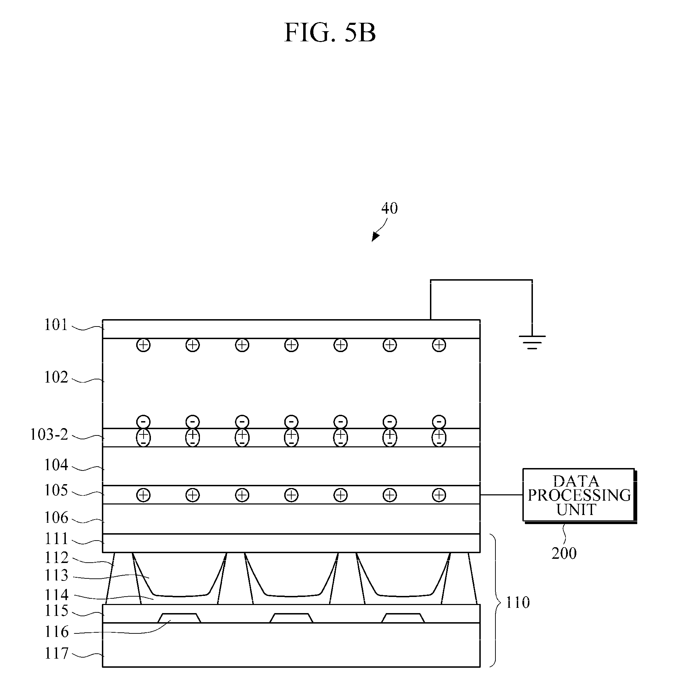

Due to the movement of the negative charges toward the dielectric layer 103-2, the dielectric layer 103-2 may be polarized, and dipoles may be generated in the dielectric layer 103-2. The dipoles in the dielectric layer 103-2 may be arranged in a manner shown in FIG. 5B.

Due to the pattern of the arrangement of the dipoles in the dielectric layer 103-2, a lower transparent electrode layer 105 may be charged with positive charges, and particularly, as many positive charges as there are dipoles in the dielectric layer 103-2.

An image read-out operation will hereinafter be described in detail.

The upper electrode layer 101 may be connected to a ground source. Then, if a first row of pixels in a PDP 110 is turned on, plasma light may be emitted from the first row of pixels. The plasma light may transmit through the lower transparent electrode layer 105 and may thus reach a second photoconductive layer 104.

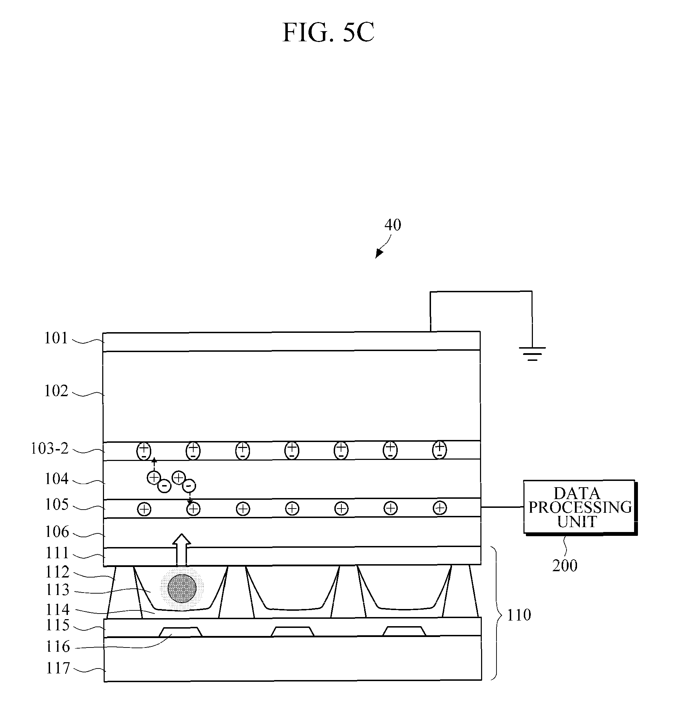

Referring to FIG. 5C, pairs of positive and negative charges may be generated in the second photoconductive layer 104, and particularly, in a portion of the second photoconductive layer 104 corresponding to the first row of pixels, upon exposure to the plasma light emitted from the first row of pixels. The positive and negative charges generated in the second photoconductive layer 104 may be electrically attracted to the dielectric layer 103-2 and the lower transparent electrode layer 105, respectively, and may thus be separated from each other.

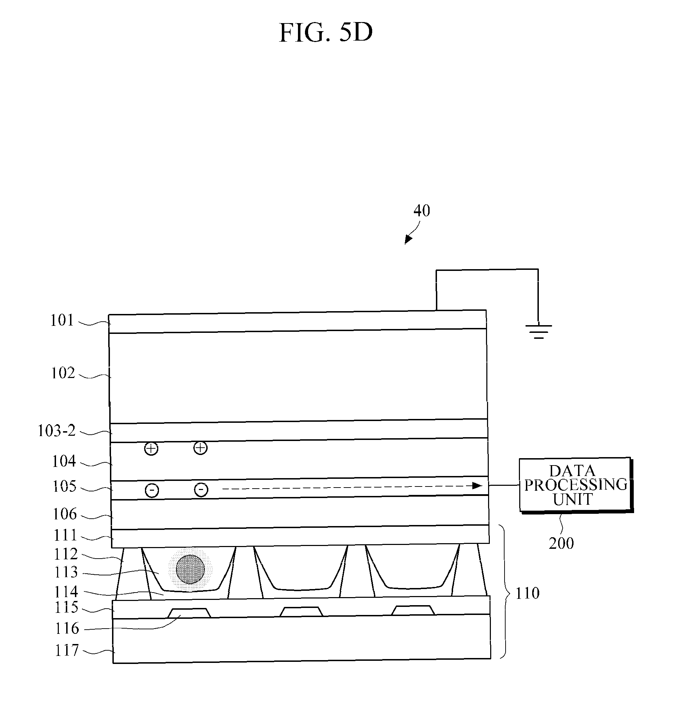

Referring to FIG. 5D, due to the positive charges in the lower transparent electrode layer 105, negative charges may be read out from the portion of the second photoconductive layer 104 corresponding to the first row of pixels by the data processing unit 200. Then, the read-out negative charges may be subjected to image processing performed by the data processing unit 200. The positive charges generated in the second photoconductive layer 104 may move toward the dielectric layer 103-2 due to the dipoles in the dielectric layer 103-2.

Thereafter, the first row of pixels may be turned off, and a second row of pixels may be turned on. Then, the second row of pixels may emit plasma light. Due to the plasma light, pairs of positive and negative charges may be generated in a portion of the second photoconductive layer 104 corresponding to the second row of pixels. The positive and negative charges generated in the second photoconductive layer 104 may be electrically attracted to the metal layer 103-1 and the lower transparent electrode layer 105, respectively, and may thus be separated from each other. Due to the positive charges in the lower transparent electrode layer 105, negative charges may be read out from the portion of the second photoconductive layer 104 corresponding to the second row of pixels by the data processing unit 200. Then, the read-out negative charges may be subjected to image processing performed by the data processing unit 200.

Thereafter, the same operation as that performed on the first and second rows of pixels may also be performed on a third row of pixels. As a result, negative charges may be read out from a portion of the second photoconductive layer 104 corresponding to the third row of pixels by the data processing unit 200. Then, the read-out negative charges may be subjected to image processing performed by the data processing unit 200.

By performing the above-mentioned operation on all rows of pixels in the PDP 110, it is possible to obtain a radiation image of an object, if any, placed on the apparatus 40.

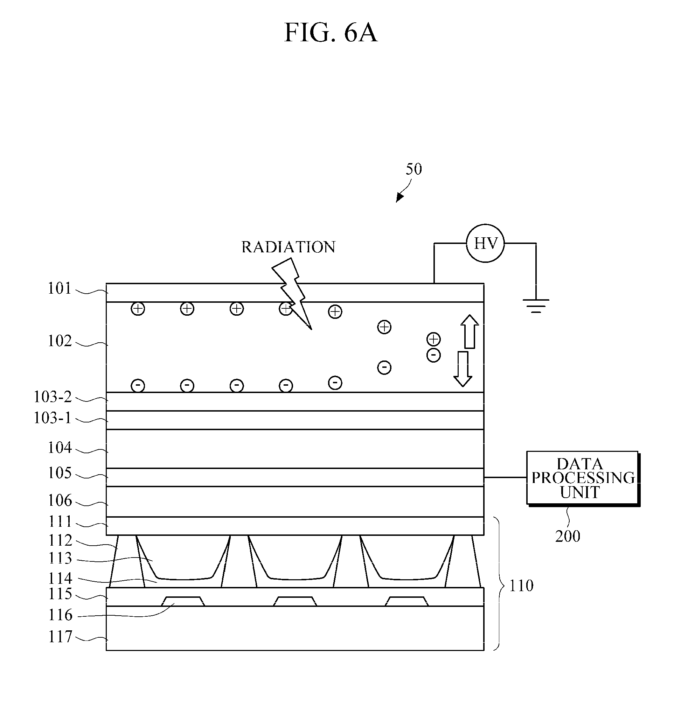

FIGS. 6A through 6D are cross-sectional views for explaining the operation of another exemplary apparatus 50 for detecting radiation, which includes both a metal layer 103-2 and a dielectric layer 103-2 that serve together as a charge trapping layer. The apparatus 50 is the same as the apparatus 20 shown in FIG. 3 except that it includes the metal layer 103-1 and the dielectric material 103-2 as a charge trapping layer.

Referring to FIG. 6A, when radiation such as X-rays is applied to the apparatus 50, the radiation may be transmitted to a first photoconductive layer 102 through an upper electrode layer 101, and pairs of positive and negative charges may be generated in the first photoconductive layer 102. When a high voltage HV is applied to the upper electrode layer 101, the positive and negative charges may be separated from each other and may move toward opposite directions. More specifically, if a negative voltage is applied to the first photoconductive layer 102, the positive charges in the first photoconductive layer 102 may move toward the upper electrode layer 101, and the negative charges in the first photoconductive layer 102 may move toward the dielectric layer 103-2.

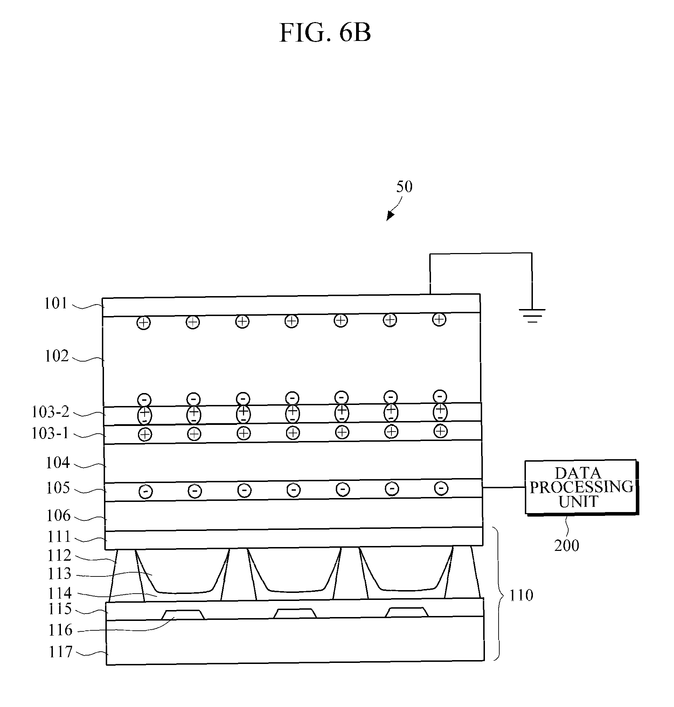

Due to the movement of the negative charges toward the dielectric layer 103-2, the dielectric layer 103-2 may be polarized, and dipoles may be generated in the dielectric layer 103-2. The dipoles in the dielectric layer 103-2 may be arranged in a manner shown in FIG. 6B.

Due to the pattern of the arrangement of the dipoles in the dielectric layer 103-2, the metal layer 103-1 may be charged with positive charges. A lower transparent electrode layer 105 may be charged with negative charges due to the positive charges in the metal layer 103-1. More specifically, the lower transparent electrode layer 105 may be charged with as many negative charges as there are dipoles in the dielectric layer 103-2.

A radiation image read-out operation will hereinafter be described in detail.

The upper electrode layer 101 may be connected to a ground source. Then, if a first row of pixels in a PDP 110 is turned on, plasma light may be emitted from the first row of pixels. The plasma light may transmit through the lower transparent electrode layer 105 and may thus reach a second photoconductive layer 104.

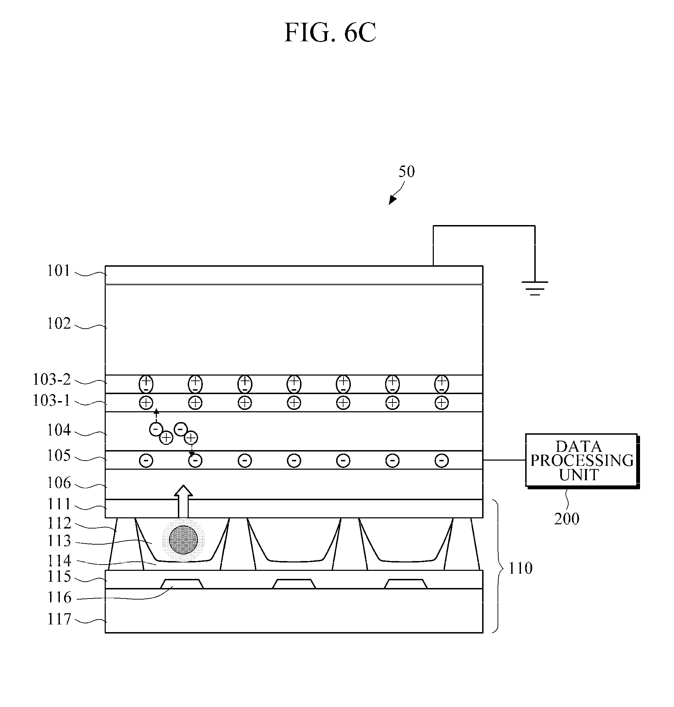

Referring to FIG. 6C, pairs of positive and negative charges may be generated in the second photoconductive layer 104, and particularly, in a portion of the second photoconductive layer 104 corresponding to the first row of pixels, upon exposure to the plasma light emitted from the first row of pixels. The positive and negative charges generated in the second photoconductive layer 104 may be electrically attracted to the metal layer 103-1 and the lower transparent electrode layer 105, respectively, and may thus be separated from each other.

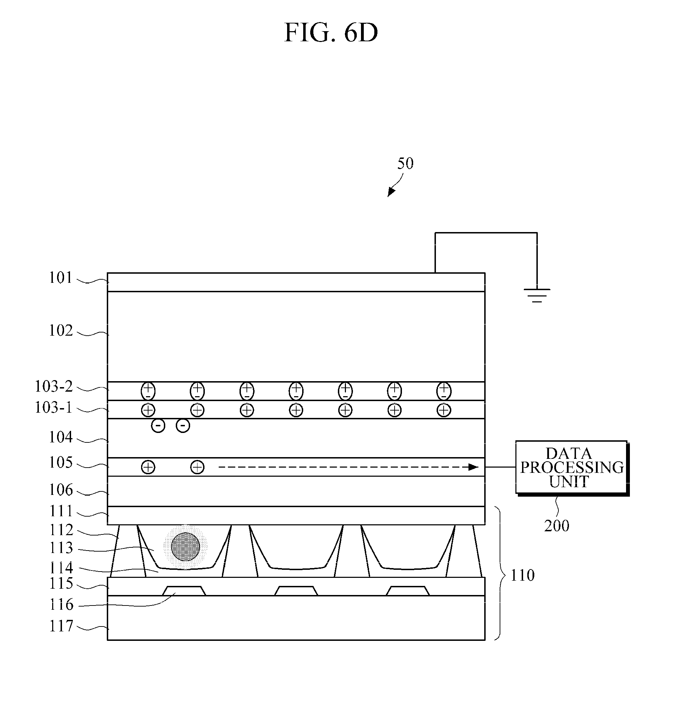

Referring to FIG. 6D, due to the negative charges in the lower transparent electrode layer 105, positive charges may be read out from the portion of the second photoconductive layer 104 corresponding to the first row of pixels by the data processing unit 200. Then, the read-out positive charges may be subjected to image processing performed by the data processing unit 200.

Thereafter, the first row of pixels may be turned off, and a second row of pixels may be turned on. Then, the second row of pixels may emit plasma light. Due to the plasma light, pairs of positive and negative charges may be generated in a portion of the second photoconductive layer 104 corresponding to the second row of pixels. The positive and negative charges generated in the second photoconductive layer 104 may be electrically attracted to the metal layer 103-1 and the lower transparent electrode layer 105, respectively, and may thus be separated from each other. Due to the negative charges in the lower transparent electrode layer 105, positive charges may be read out from the portion of the second photoconductive layer 104 corresponding to the second row of pixels by the data processing unit 200. Then, the read-out positive charges may be subjected to image processing performed by the data processing unit 200.

Thereafter, the same operation as that performed on the first and second rows of pixels may also be performed on a third row of pixels. As a result, positive charges may be read out from a portion of the second photoconductive layer 104 corresponding to the third row of pixels by the data processing unit 200. Then, the read-out positive charges may be subjected to image processing performed by the data processing unit 200.

By performing the above-mentioned operation on all rows of pixels in the PDP 110, it is possible to obtain a radiation image of an object, if any, placed on the apparatus 50.

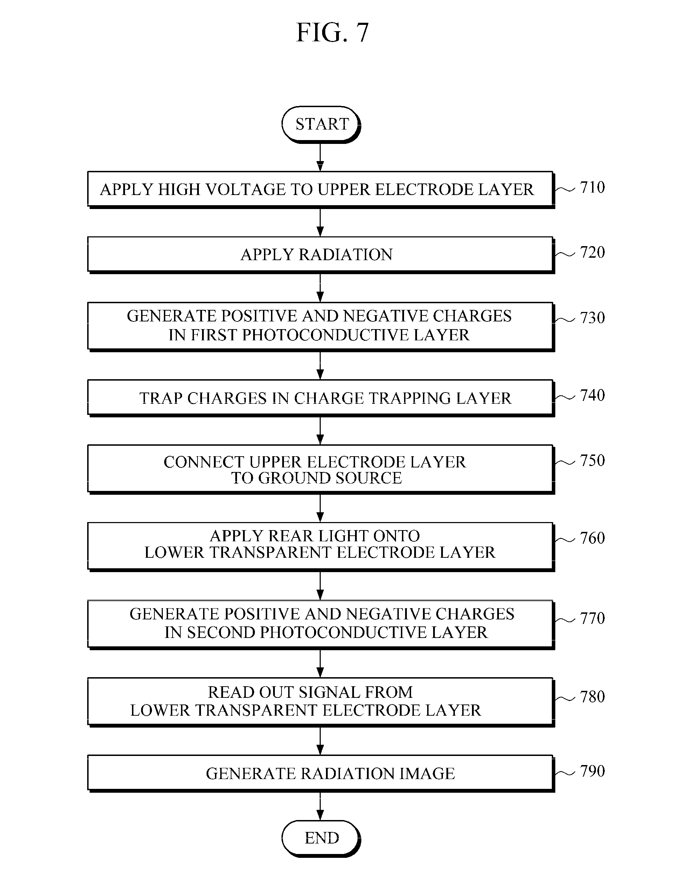

FIG. 7 is a flowchart of an exemplary method of detecting radiation. Referring to FIG. 7, a high voltage may be applied to the upper electrode layer 101 (710), and radiation may be applied onto the upper electrode layer 101 (720). Pairs of positive and negative charges may be generated in the first photoconductive layer 102 (730). The positive and negative charges may be separated from each other and may move toward the upper electrode layer 101 and the charge trapping layer 103, respectively. As a result, either the positive or negative charges may accumulate in the charge trapping layer 103 (740). More specifically, if a negative voltage is applied to the upper electrode layer 101, negative charges may be trapped in the charge trapping layer 103, and thus, the lower transparent electrode layer 105 may be charged with the opposite polarity to that of the charges trapped in the charge trapping layer 103.

The application of a high voltage to the upper electrode layer may be terminated, and the upper electrode layer 101 may be connected to a ground source (750). Thereafter, if rear light such as plasma light is applied (760), pairs of positive and negative charges may be generated in the second photoconductive layer 104 (770).

Thereafter, a signal corresponding to the charges trapped in the charge trapping layer 103 may be read out from the lower transparent electrode layer 105 due to the positive or negative charges in the second photoconductive layer 104 (780). Thereafter, a radiation image may be generated based on the read-out signal (790).

More specifically, if the charge trapping layer 103 includes a dielectric layer, the charge trapping layer 103 may be polarized due to the positive or negative charges in the first photoconductive layer 102, and thus, dipoles may be generated and arranged in the charge trapping layer 103. Due to the pattern of the arrangement of the dipoles in the charge trapping layer 103, the lower transparent electrode layer 105 may be charged, and thus, the positive or negative charges in the second photoconductive layer 104 may be attracted to the lower transparent electrode layer 105. In this manner, a signal reflecting the arrangement of the dipoles in the charge trapping layer 103 can be read out from the lower transparent electrode layer 105.

Alternatively, if the charge trapping layer 103 includes a dielectric layer and a metal layer and the dielectric layer and the metal layer contact the first photoconductive layer 102 and the second photoconductive layer 104, respectively, the dielectric layer may be polarized due to the positive or negative charges trapped in the charge trapping layer 103, and thus, dipoles may be generated and arranged uniformly in the dielectric layer. The metal layer may be charged according to the pattern of the arrangement of the dipoles in the dielectric layer.

As a result, the lower transparent electrode layer 105 may be charged with the opposite polarity to that of the charges in the metal layer, e.g., positive charges. During a radiation image read-out operation, positive charges generated in the second photoconductive layer 104 upon exposure to rear light may be attracted to the lower transparent electrode layer 105, and thus, a signal reflecting the arrangement of the dipoles in the dielectric layer or corresponding to the charges in the metal layer may be read out from the lower transparent electrode layer 105.

The methods and/or operations described above may be recorded, stored, or fixed in one or more computer-readable storage media that includes program instructions to be implemented by a computer to cause a processor to execute or perform the program instructions. The media may also include, alone or in combination with the program instructions, data files, data structures, and the like. Examples of computer-readable storage media include magnetic media, such as hard disks, floppy disks, and magnetic tape; optical media such as CD ROM disks and DVDs; magneto-optical media, such as optical disks; and hardware devices that are specially configured to store and perform program instructions, such as read-only memory (ROM), random access memory (RAM), flash memory, and the like. Examples of program instructions include machine code, such as produced by a compiler, and files containing higher level code that may be executed by the computer using an interpreter. The described hardware devices may be configured to act as one or more software modules in order to perform the operations and methods described above, or vice versa. In addition, a computer-readable storage medium may be distributed among computer systems connected through a network and computer-readable codes or program instructions may be stored and executed in a decentralized manner.

As apparently described above, it is possible to provide an apparatus and method for detecting radiation, which can improve the resolution of a radiation image and can contribute to the simplification of the manufacture of the apparatus.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

## Claims

1.  An apparatus for detecting radiation, the apparatus comprising:

    an upper electrode layer transmitting radiation;
    a first photoconductive layer becoming photoconductive upon exposure to the radiation and thus generating charges therein;
    a charge trapping layer trapping therein the charges generated in the first photoconductive layer and serving as a floating electrode;
    a second photoconductive layer becoming photoconductive upon exposure to rear light for reading out a radiation image;
    a lower transparent electrode layer charged with the charges trapped in the charge trapping layer; and
    a rear light emission unit applying the rear light to the second photoconductive layer via the lower transparent electrode layer in units of pixels.

2.  The apparatus of claim 1, further comprising a data processing unit reading out a signal corresponding to the charges trapped in the charge trapping layer from the lower transparent electrode layer and generating a radiation image based on the read-out signal.

3.  The apparatus of claim 1, wherein the charge trapping layer includes a metal layer.

4.  The apparatus of claim 1, wherein the charge trapping layer includes a dielectric layer.

5.  The apparatus of claim 1, wherein the charge trapping layer includes a metal layer and a dielectric layer.

6.  The apparatus of claim 1, wherein the rear light emission unit comprises two substrates facing each other, a plurality of barrier ribs defining a cell structure between the two substrates, a gas layer disposed in an inner chamber inside the cell structure and emitting plasma light, and a plasma display panel (PDP) providing the plasma light to the lower transparent electrode layer as the rear light.

7.  The apparatus of claim 1, wherein, during the trapping of charges in the charge trapping layer, a high voltage is applied to the upper electrode layer, and during the reading out of charges from the lower transparent electrode layer, the upper electrode is connected to a ground source.

8.  A method of detecting radiation, which is performed by an apparatus for detecting radiation, including an upper electrode layer transmitting radiation, a first photoconductive layer becoming photoconductive upon exposure to the radiation and thus generating charges therein, a charge trapping layer trapping therein the charges generated in the first photoconductive layer and serving as a floating electrode, a second photoconductive layer becoming photoconductive upon exposure to rear light for reading out a radiation image, a lower transparent electrode layer charged with the charges trapped in the charge trapping layer, and a rear light emission unit applying the rear light to the second photoconductive layer via the lower transparent electrode layer in units of pixels, the method comprising:

    generating pairs of positive and negative charges in the first photoconductive layer upon exposure to radiation when applying a high voltage to the upper electrode layer;
    separating the positive and negative charges from each other and moving the positive and negative charges toward the upper electrode layer and the charge trapping layer, respectively;
trapping the positive or negative charges in the charge trapping layer;
connecting the upper electrode layer to a ground source and generating pairs of positive and negative charges in the second photoconductive layer upon exposure to the rear light; and
reading out a signal corresponding to the charges trapped in the charge trapping layer from the lower transparent electrode layer, the charges trapped in the charge trapping layer originating from the second photoconductive layer.

9. The method of claim 8, further comprising generating a radiation image based on the read-out signal.

10. The method of claim 8, wherein the charge trapping layer includes a metal layer.

11. The method of claim 8, wherein the charge trapping layer includes a dielectric layer.

12. The method of claim 11, wherein the reading out of the signal comprises:

   generating and arranging dipoles in the dielectric layer by polarizing the dielectric layer upon the movement of positive or negative charges toward the charge trapping layer; and
   reading out a signal corresponding to the arrangement of the dipoles in the dielectric layer from the lower transparent layer using the charges transmitted from the second photoconductive layer.

13. The method of claim 8, wherein the charge trapping layer includes a metal layer and a dielectric layer.

14. The method of claim 8, wherein the reading out of the signal comprises:

   if the charge trapping layer includes a metal layer and a dielectric layer and the dielectric layer and the metal layer contact the first and second photoconductive layers, respectively, generating and arranging dipoles in the dielectric layer by polarizing the dielectric layer upon the movement of positive or negative charges toward the charge trapping layer; and
   charging the metal layer with charges corresponding to the arrangement of the dipoles in the charge trapping layer;
   charging the lower transparent layer with an opposite polarity to that of the charges that the metal layer is charged with; and
   reading out a signal corresponding to the arrangement of the dipoles in the dielectric layer or the charges that the metal layer is charged with from the lower transparent layer.

# FIG. 1

10

| UPPER ELECTRODE LAYER | 101 |
| FIRST PHOTOCONDUCTIVE LAYER | 102 |
| CHARGE TRAPPING LAYER | 103 |
| SECOND PHOTOCONDUCTIVE LAYER | 104 |
| LOWER TRANSPARENT ELECTRODE LAYER | 105 |

LIGHT SOURCE

DATA PROCESSING UNIT

200

# FIG. 2

# FIG. 3

20

| UPPER ELECTRODE LAYER | 101 |
|---|---|
| FIRST PHOTOCONDUCTIVE LAYER | 102 |
| CHARGE TRAPPING LAYER | 103 |
| SECOND PHOTOCONDUCTIVE LAYER | 104 |
| LOWER TRANSPARENT ELECTRODE LAYER | 105 |

106

111

112

113

114

115

116

117

110

DATA
PROCESSING
UNIT

200

FIG. 4A

# FIG. 4B

30

101

102

103-1

104

105

106

111

112

113

114

115

116

117

DATA
PROCESSING
UNIT

200

# FIG. 4C

30

101
102
103-1
104
105
106
111
112
113
114
115
116
117

LIGHT

ON    OFF    OFF

# FIG. 4D

# FIG. 4E

30

101

102

103-1

104

105

106

111

112

113

114

115

116

117

⊖  ⊖  ⊖  ⊖  ⊖  ⊖  ⊖

⊕  ⊕

⊖  ⊖  ------------------>

OFF          ON          OFF

DATA
PROCESSING
UNIT

200

# FIG. 5A

# FIG. 5B

40

DATA PROCESSING UNIT

200

110

# FIG. 5C

# FIG. 5D

# FIG. 6A

RADIATION

HV

101

102

103-2
103-1

104

105

106

111
112
113
114
115
116
117

50

DATA
PROCESSING
UNIT

200

110

# FIG. 6B

50

101

102

103-2
103-1

104

105

106

111
112
113
114
115
116
117

DATA
PROCESSING
UNIT

200

110

# FIG. 6C

50

101

102

103-2

103-1

104

105

106

111

112

113

114

115

116

117

110

DATA
PROCESSING
UNIT

200

# FIG. 6D

50

101
102
103-2
103-1
104
105
106
111
112
113
114
115
116
117

DATA
PROCESSING
UNIT

200

110

# FIG. 7

START

APPLY HIGH VOLTAGE TO UPPER ELECTRODE LAYER — 710

APPLY RADIATION — 720

GENERATE POSITIVE AND NEGATIVE CHARGES
IN FIRST PHOTOCONDUCTIVE LAYER — 730

TRAP CHARGES IN CHARGE TRAPPING LAYER — 740

CONNECT UPPER ELECTRODE LAYER
TO GROUND SOURCE — 750

APPLY REAR LIGHT ONTO
LOWER TRANSPARENT ELECTRODE LAYER — 760

GENERATE POSITIVE AND NEGATIVE CHARGES
IN SECOND PHOTOCONDUCTIVE LAYER — 770

READ OUT SIGNAL FROM
LOWER TRANSPARENT ELECTRODE LAYER — 780

GENERATE RADIATION IMAGE — 790

END

## INTERNATIONAL SEARCH REPORT

International application No.

**PCT/KR2010/006689**

| A. | CLASSIFICATION OF SUBJECT MATTER |
|---|---|

*H01L 31/115(2006.01)i, G01T 1/24(2006.01)i*

According to International Patent Classification (IPC) or to both national classification and IPC

| B. | FIELDS SEARCHED |
|---|---|

Minimum documentation searched (classification system followed by classification symbols)
H01L 31/115; G01T 1/16; G01T 1/00; H01L 31/09; G01T 1/24; H01L 27/14

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: photoconductive layer & resolution & electric charge

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2008-0056641 A (NATIONAL UNIVERSITY CORPORATION SHIZUOKA UNIVERSITY et al.) 23 June 2008<br>See abstract, [0009]-[0011], [0015]-[0019], claims 1-5 and figures 1-4. | 1-14 |
| A | JP 2005-268722 A (TOSHIBA CORP et al.) 29 September 2005<br>See abstract, claims 1, 3 and figures 1-2. | 1-14 |
| A | JP 2005-033002 A (TOSHIBA CORP et al.) 03 February 2005<br>See abstract, [0019]-[0022], claims 1-8 and figures 1-2. | 1-14 |
| A | JP 2007-059798 A (TOSHIBA CORP et al.) 08 March 2007<br>See abstract, [0003]-[0004], claims 1-2 and figures 1-3. | 1-14 |

| ☐ | Further documents are listed in the continuation of Box C. | ☒ | See patent family annex. |
|---|---|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 14 JUNE 2011 (14.06.2011) | **15 JUNE 2011 (15.06.2011)** |

| Name and mailing address of the ISA/KR | Authorized officer |
|---|---|
| Korean Intellectual Property Office<br>Government Complex-Daejeon, 139 Seonsa-ro, Daejeon 302-701, Republic of Korea<br>Facsimile No. 82-42-472-7140 | Telephone No. |

Form PCT/ISA/210 (second sheet) (July 2009)

INTERNATIONAL SEARCH REPORT
Information on patent family members

International application No.

**PCT/KR2010/006689**

| Patent document cited in search report | Publication date | Patent family member | Publication date |
|---|---|---|---|
| KR 10-2008-0056641 A | 23.06.2008 | CN 101206263 A | 25.06.2008 |
| | | CN 101206263 A0 | 25.06.2008 |
| | | EP 1936693 A2 | 25.06.2008 |
| | | EP 1936693 A3 | 11.03.2009 |
| | | EP 1936693 B1 | 16.02.2011 |
| | | JP 2008-153459 A | 03.07.2008 |
| | | US 2008-0164412 A1 | 10.07.2008 |
| | | US 7547885 B2 | 16.06.2009 |
| JP 2005-268722 A | 29.09.2005 | JP 2005-268722 A | 29.09.2005 |
| JP 2005-033002 A | 03.02.2005 | JP 2005-033002 A | 03.02.2005 |
| JP 2007-059798 A | 08.03.2007 | US 2007-0045554 A1 | 01.03.2007 |

Form PCT/ISA/210 (patent family annex) (July 2009)